Europäisches Patentamt

European Patent Office

Office européen des brevets

(19)

(11) Publication number: **0 041 531
B1**

# (12) EUROPEAN PATENT SPECIFICATION

(45) Date of publication of patent specification :
14.09.83

(51) Int. Cl.³ : **F 25 B 21/02**, F 25 B 29/00

(21) Application number : **81900024.1**

(22) Date of filing : **05.12.80**

(86) International application number :
**PCT/SE 80/00320**

(87) International publication number :
**WO WO/81017 (25.06.81 Gazettee 81/15)**

(54) **DEVICE FOR COLD OR WARM STORAGE.**

(30) Priority : **07.12.79 SE 7910091**

(43) Date of publication of application :
**16.12.81 Bulletin 81/50**

(45) Publication of the grant of the patent :
**14.09.83 Bulletin 83/37**

(84) Designated contracting states :
**FR**

(56) References cited :
**DE A 1 539 329
DE B 1 151 262
US A 3 031 855
US A 3 111 008
US A 3 177 670
US A 3 307 364**

(73) Proprietor : **SUPERCOOL AB
Box 27
S-40120 Göteborg (SE)**

(72) Inventor : **CECH, Pavel
Odenius väg 13
S-443 00 Lerum (SE)**
Inventor : **HURTIG, Bernt Gunnar
Äivsborgsgatan 33
S-414 72 Göteborg (SE)**

(74) Representative : **Chauchard, Robert et ai
c/o Cabinet Malémont 42, avenue du Président
Wilson
F-75116 Paris (FR)**

Device for cold or warm storage

The present invention relates to a device for the cooling or heating of a storage space provided with heat insulating walls, of the type comprising a thermoelectric heat pump arranges to transmit heat between a heat exchanging element inside said space and a heat exchanging element exposed to an outer medium, for example the atmospheric air, said thermoelectric heat pump comprising at least two substantially identical units or groups of units arranged each to transmit a portion of the pumped heat flow, a source of direct current feeding said heat pump, and a series-parallel switch arranged to connect said units or groups of units to the source of direct current in series or in parallel with each other.

In a refrigerator or a cupboard for warm storage, it is a requirement that the cooling or heating power is sufficient not only to maintain a steady state condition but also to effect a cooling or heating, respectively, of the storage space and the goods contained therein to the storage temperature prescribed within a reasonable period of time after a shutdown or after the insertion into said storage space of a charge of goods having a temperature strongly differring from the prescribed storing temperature. The pumped heat power required therefor is much larger than the one required for maintaining the steady state condition, in which the pumped power is only required to balance the flow of heat through the heat insulation of the storage space from and to the surrounding air, respectively, under the action of the temperature difference between the storage space and the surrounding air.

Certain known devices of this kind are provided with on-off control means. A temperature sensing device, for instance a bimetal strip, placed inside the (cold) storage space, actuates a switch arranged to close the electric circuit of the heat pump when the temperature rises above a certain limit, and to open the circuit as soon as the temperature drops below a certain limit. The efficiency of the device, that is the ratio of the pumped heat power to the consumed electric power, is very low for this control system. This is also the case for a modified system in which the heat pump is permanently connected to the power source through a series resistance and connected in parallel with a shunt branch containing a bimetal switch in series with a shunt resistance.

In another known device (according to DE-B-1 065 863) the heat pump is permanently connected to the power source through a controlled semiconductor (transistor) the control voltage of which is supplied by a potentiometer circuit including a thermistor constituting the temperature sensing member of the device. In this device the efficiency (as defined above) is low in the steady state, a large portion of the power supplied being inevitably consumed by the transistor serving as a series resistance.

Other known control devices, for instance according to DE-B-1 126 425 or US-A-3 177 670, require a power source having switching means to provide one or the other of two different output voltages, or an AC mains to serve as the primary source of power, respectively.

In particular, US-A-3 177 670 discloses a device for cooling the freezer and cooler compartments of a thermo-electric refrigerator. This device comprises a power source having switching means for providing one or the other of two different output voltages corresponding to two different cooling operations, and two groups of units of thermo-electric modules, the two groups being connected in series whereas the units of one of said groups are connected either in parallel or in series depending on the desired cooling operation.

The main object of the device according to the US document is to provide a refrigerator wherein the temperature maintained in the freezer compartment is sufficient to ensure that water and other products in said freezer compartment freeze at a rate practically equal when the device is either on low cooling or on high cooling.

This object does not satisfy the requirement mentioned in the second paragraph above.

On the other hand, the present invention relates to a device of the above mentioned type, which fully satisfies said requirement, said device being characterized in that said source of direct current is of a substantially constant voltage, and in that said units or groups of units are characterized by such a relation between the pumped heat power and the operating current that the highest current which can be caused by said source of current to flow through the series connected units or groups of units is considerably lower than the current caused to flow through the parallel connected units or groups of units when the maximum pumped heat power is to be attained.

The source of direct current of the device according to the present invention includes such sources as batteries, the output voltage of which may vary with the load or with the state of charging, but excludes sources of direct current having switching means for providing different operating voltages for the heat pump.

The device of the invention is of vital importance in many cases, namely in battery operated mobile refrigerating installations in cars and boats.

When this device is in use, the change-over switch is set in the parallel position when a high pumped power is required, for instance when a refrigerator is put into use after a period of non-operation or when a large batch of still warm goods to be refrigerated has been put in. The change-over switch is set in the series position when a steady-state condition has been attained. The operation of the change-over switch can be performed manually or automatically.

The series connection limits the current flowing through each unit or group of units to a low value. This results in a good efficiency of the device in the steady-state condition. The improved efficiency is due on one hand to the fact that there are no losses, or small losses only, caused by power dissipation in series connected control elements, and on the other hand by the fact that the efficiency of a thermo-electric heat pump is best at relatively low currents. The connection in parallel permits an increase of the current through each unit or group of units to a much higher value, resulting in a large increase of the pumped power. The corresponding drop in efficiency is comparatively unimportant ; as the duration of cooling or heating periods is small compared to the duration of the steady-state condition. The power consumption required for the cooling or heating to the storage temperature will be a small portion only of the total power consumption of the device.

In the device according to the invention, the required control of the current through the series connected units or groups of units dependent on the temperature of the storage space can according to the same be performed continuously or discontinuously, as will be explained in the following description of embodiments of the invention with reference to the accompanying drawing, in which

Figure 1   is a circuit diagram of a first embodiment of the invention,

Figure 2   is a diagram illustrating the function of the device according to Fig. 1,

Figure 3   is a circuit diagram of a second embodiment of the invention,

Figure 4   is a vertical cross-sectional view through the wall of a refrigerator with refrigerating equipment of the type represented in Fig. 3,

Figure 5   is a section taken along the line V-V in Fig. 4, and

Figure 6   is a view from the outside (from the right in Fig. 4) of the device according to Fig. 4.

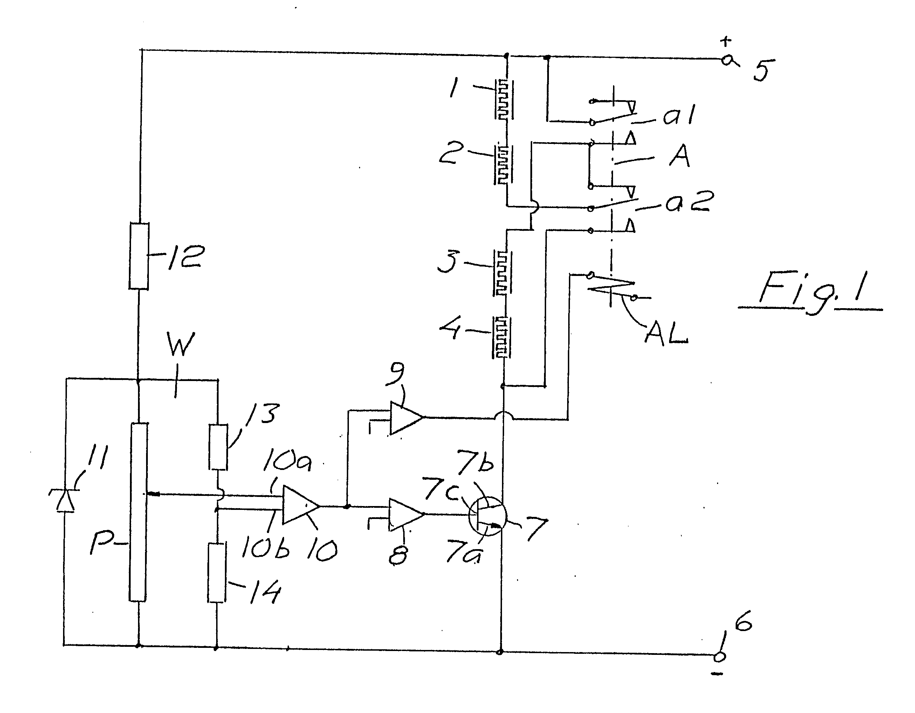

The apparatus illustrated in Fig. 1 includes a thermo-electric heat pump comprising two pairs of identical units 1, 2 and 3, 4, each of which comprises a pile of Peltier elements connected in series with each other. The units 1, 2 and 3, 4 of each of the pairs are permanently connected in series with each other. The heat pump is assumed to be mounted in the wall of a refrigerator or the like. The cold side of the heat pump is assumed to be connected to a cooling element inside the refrigerator, while the warm side of the heat pump is connected to an element exposed to the outer air or any other cooling agent. The pairs of units 1-2 and 3-4 are connected with a make contact a1 and a change-over contact a2 of a relay switch A having an energizing winding AL. The switch A is shown in the rest position (winding AL currentless) in which the pairs 1-2 and 3-4 are connected in series with each other through the switch-over contact a2. In the operated position of the switch A (winding AL energized) the pair 1-2 is connected in parallel to the pair 3-4 through the make contact a1 and the switch-over contact a2.

The resulting series or parallel connection of the pairs 1-2 and 3-4 is connected in circuit with the terminals 5, 6 of a direct current source in series with a transistor 7 having the emitter 7a, the collector 7b and the base 7c. The base 7c is connected to the output terminal of an amplifier 8. The amplifier 8 as well as an amplifier 9 feeding the energizing winding AL is controlled by a pre-amplifier 10, the input leads 10a, 10b of which carry a control voltage supplied by a bridge W, energized by a constant voltage provided by a Zener diode 11, which is connected to the terminals 5, 6 in series with a resistor 12. One branch of the bridge comprises a resistor 13 in series with a thermistor 14 of NTC-type (i. e. with a negative temperature coefficient). The thermistor 14 is placed inside the refrigerated space or directly on the cooling element and constitutes the temperature sensing means of the device. The other branch of the bridge consists of a potentiometer P. The input lead 10a of tha amplifier 10 permanently exhibits a positive potential with respect to the input lead 10b. The difference between the potentials of the input leads 10a and 10b constitutes the control voltage of the amplifier 10. An increase of the temperature inside the refrigerator causes a reduction of the resistance of the thermistor 14 and, consequently, a reduction of the potential of the input lead 10b, resulting in an increase of the control voltage carried by the input leads 10a and 10b and a corresponding increase of the control voltage supplied to the transistor 7 by the amplifier 8 and of the heat pump current controlled by the transistor.

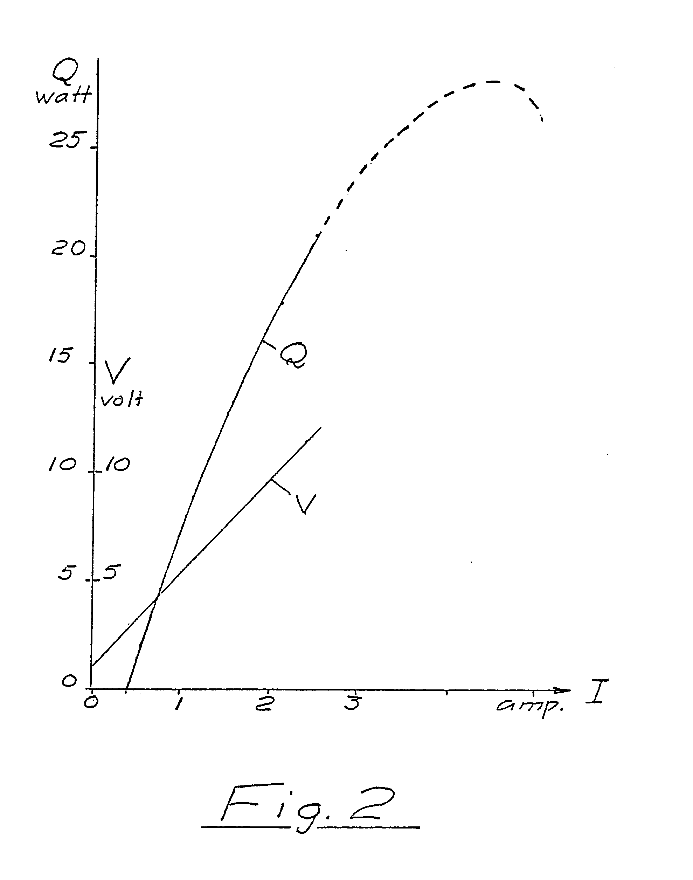

Fig. 2 shows how the pumped heat power Q and the voltage V for each of the pairs 1-2 and 3-4 varies with the operating current I. The diagram was established at a temperature of 27 °C on the warm side and a temperature of 7 °C on the cold side.

It is now assumed that the current source is a storage battery having a voltage of 12 volts. The diagram shows that an operating current of approx. 1 amp or slightly more can be supplied to two pairs connected in series, before the voltage across said series connection approaches said available voltage. An operating current of 1 amp corresponds to a pumped power of approximately 7 watts per pair of elements, a pumped power of approximately 14 watts for the two pairs of elements connected in series.

Let it be assumed that the size of the refrigerator served by the heat pump, the quality of its insulation and the environment in which it operates are such that the pumped power above indicated normally quite suffices to keep the refrigerator cold. As long as this is the case, the pairs 1-2 and 3-4 remain connected in series with each other. The device then operates with a low power consumption and a high efficiency, i. e. a high relation between pumped power and electric power consumption. At a current of 1 amp, the pumped power is 2 · 7 = 14 watts and the electric power consumption 12 watts, corresponding to an efficiency figure of 14 : 12 = 117 %.

On certain occasions, however, a larger pumped power is required. This is, for instance, the case when the refrigerator is put into service after an idle period, or when a large load of still warm goods to be kept cool has been put in. The temperature in the refrigerator will then be so high that the transistor 10 under the action of its temperature depending control voltage tends to increase the current intensity to a value above the maximum possible for the series connection of the pairs 1-2 and 3-4. The switch A is arranged to operate when the thermistor 14 senses a temperature slightly above the one at which the current through the series connection of the pairs 1-2 and 3-4 attains its maximum. The operation of the switch A causes its contacts a1, a2 to connect the pairs 1-2 and 3-4 in parallel. Each one of the pairs 1-2 and 3-4 is supplied with a voltage of nearly 12 volts (the voltage drop over the fully conducting transistor being low), resulting in a current of about 2,5 amp through each one of the pairs.

The parallel connection causes a comparatively high power consumption and a comparatively low efficiency. A current of 2,5 amp per unit will according to the diagram of Fig. 2 produce a total pumped power of 2 times 21 watts. The resulting efficiency ratio is 42 : 60 = 70 %. The high power consumption is, however, of comparatively short duration, as the parallel connection will be discontinued as soon as the temperature in the refrigeration compartment has dropped to a value just below the one at which the switch A was operated. The drop-off of the switch A restores the series connection of the pairs 1-2 and 3-4.

It will be noted from Fig. 2 that the pumped power rises with the current to a maximum. For currents beyond said maximum the pumped power drops rapidly. It is obvious that it is generally unadvisable to operate the heat pump unit with a current high enough to cause the pumped heat power to reach its maximum, as the increase of the pumped power to be obtained thereby is small compared with the increase of the power loss. The device should therefore be arranged to provide automatically a limitation of the current through the parallel connected pairs to a suitable value. In the example described above this has been obtained simply by a suitable choice of electrical data of the pairs 1-2 and 3-4.

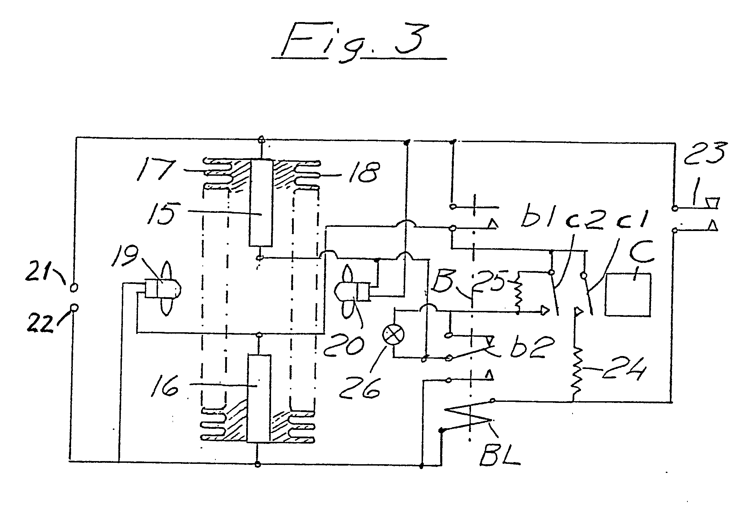

The device illustrated in Fig. 3 is provided with a thermo-electric heat pump comprising two units 15, 16 of identical design, each of which comprises a large number of electrically series connected thermoelements. The heat pump is assumed to be mounted in the wall of a refrigerator or the like. The cold side of the heat pump is connected with a cooling element 17 inside the refrigerator, while the warm side is connected with a heat exchanging element 18 exposed to the outer air. A fan 19 driven by an electric motor causes the air in the refrigerator to circulate past the cooling element 17 in order to improve the heat transfer to the same and thereby reduce the temperature difference between the element 17 and the air in the refrigerator. A second fan 20 causes a flow of the outer air past the outer element 18. Each of the two fan motors is electrically connected in parallel with one of the heat pump units 15, 16. One end of the unit 15 is connected to the terminal 21 of a DC source, and one end of the unit 16 is connected to the other terminal 22 of the DC source. The other ends of the units 15, 16 are connected, respectively, to the change-over contact b2 and the make contact b1 of a relay switch B, the energizing winding BL of which can be connected with the terminals 21, 22 through a manually actuated push button contact 23 which is restored by spring action to its open position as soon as it is no longer actuated manually. A heat sensing thermostat element C mounted inside the refrigerator actuates two make contacts c1, c2, one, c1, of which is connected in series with a resistance 24 in a holding circuit for the relay switch B, while the other one make contact c2 is connected in parallel with a control resistor 25. The thermostat contacts c1, c2 are kept in the closed condition by the thermostat element C as long as the temperature in the refrigerator exceeds a predetermined value, and are disconnected, when the temperature drops below said value. The contact c1 may be adjusted in relation to the contact c2 in such a manner as to be opened at a somewhat higher temperature than the contact c2.

The functioning of the device shall now be described. It is assumed that the refrigerator has been idle and disconnected for some time and has a comparatively high temperature. The thermostat contacts c1, c2 are therefore closed. The units 15, 16 are connected in series with each other in a circuit extending from the terminal 21 through the unit 15, the switch-over contact b2 in the illustrated position, the closed thermostat contact c2 and the unit 16 to the other terminal 22 of the source of current. The flow of current through the units 15, 16 in this circuit causes cooling of the element 17 and heating of the element 18. The units 15, 16 are so adapted to the constant voltage of the current source that the total pumped heat power of the series connected units is, at normal operating temperatures in the refrigerator quite sufficient to balance the flow of heat penetrating into the refrigerator from the outside through the insulation. Said pumped heat power is, however, too low to be able to effect the desired cooling down of the refrigerator to the operating temperature within a reasonable period of time. In order to speed up the cooling-down process, the contact 23 is briefly actuated, causing the winding BL of the relay-switch to be energized. The relay switch operates its make contact b1 and change-over contact b2. The contact b2 closes a circuit from the terminal 21 through the unit 15 and the switch-over contact b2 to the terminal 22, and the contact b1 closes and a parallel circuit from the terminal 21 through the make contact b1 and the unit 16 to the terminal 22. Thus, each of the units 15, 16 now receives the full voltage of the current source. The characteristics of the units 15, 16 are so chosen that the heat power pumped by them at this operating voltage considerably exceeds the one developed in the series connection. The operation of the relay switch B also results in the closing of a holding circuit extending from the terminal 21 through the make contact b1, the closed thermostat contact c1, the resistor 24 and the winding BL to the terminal 22. Consequently, the relay switch B stays operated when the contact c2 returns to its open position. The increased pumped heat power resulting from the parallel connection causes a comparatively swift drop of the temperature in the refrigerator. When the prescribed temperature has been reached, the thermostat element c opens its contacts c1 and c2. The contact c1 switches off the holding current through the winding BL, so that the relay switch B drops off, so that the units 15 and 16 will again be connected in series through the contacts b1 and b2. The opening of the contact c2 causes the resistor 25 bridging said contact to be connected in the series circuit through the units 15 and 16. The resistance of the resistor 25 is chosen so as to reduce the heat power pumped by the units 15 and 16 to a value slightly lower than the one required for keeping the refrigerator at the prescribed temperature. Consequently, the temperature of the refrigerator tends to rise slowly, so that the thermostat contacts c1, c2 will close again after a certain time. The closing of the contact c1 causes a current to flow in a branch connected in parallel with the unit 16 and containing the contact c1 in series with the resistor 24 and the winding BL. As this branch receives one half only of the voltage of the current source and contains the series resistor 24, the current through BL will be too weak to cause the relay to operate. The closing of the contact c2 short-circuits the series resistor 25, resulting in an increase of the current through the units 16, 17 by an amount causing their pumped heat effect slightly to exceed the one required for balancing the heat flow penetrating the insulation. Consequently, the temperature of the refrigerator now tends to drop, so that after a certain period the thermostat contact c2 again opens to connect the series resistor 25 in circuit, etc.

As each of the fan motors is connected in a parallel with an individual one of the units 15, 16, the voltage supplied to each of the fan motors when the units are connected in series, is one half, and the power consumption about one fourth, of the voltage supplied and the power consumption when the units are connected in parallel. Thus, the simple arrangement described provides an automatic adjustment of the power consumption of the fans according to the need. This adjustment is especially valuable for the inner fan 19, as the power supplied to this fan adds to the heat to be pumped away by the thermo-electric heat pump.

When the relay switch B is in the operated position, a warning lamp 26 is energized in a circuit from the terminal 21 through the closed contact b1, the closed contact c2, the lamp 26 and the switch-over contact b2 in its operated position to the terminal 22.

In the above description of the functioning of the device it was assumed that the contacts c1 and c2 are opened and closed simultaneously. However, it is also possible, without causing any material change of the functioning, to adjust the contact c1 to close and open at temperatures slightly different from those at which the contact c2 closes and opens. If, for instance, the contact c1 is arranged to close at a somewhat higher temperature than the contact c2, the contact c1 remains open as long as the temperature in the refrigerator does not exceed the prescribed value. This arrangement eliminates the switching in and switching out of a current through the contact c2 which will occur when both contacts operate simultaneously.

The device described has primarily been developed for use in a mobile refrigeration installation the source of power of which is a battery. It is of course possible to provide automatic means for setting the switch in the parallel position as soon as the temperature of the refrigerator rises to a value substantially higher than the prescribed one. In a mobile refrigeration installation such an arrangement is, however, liable to cause discharge of the battery, for instance if the door of the refrigerator is inadvertently left open during a long time.

It is of course possible to replace the relay switch described by a manually operated change-over switch. In that case, the user has to take care that the switch is restored to the series position after a proper period of time.

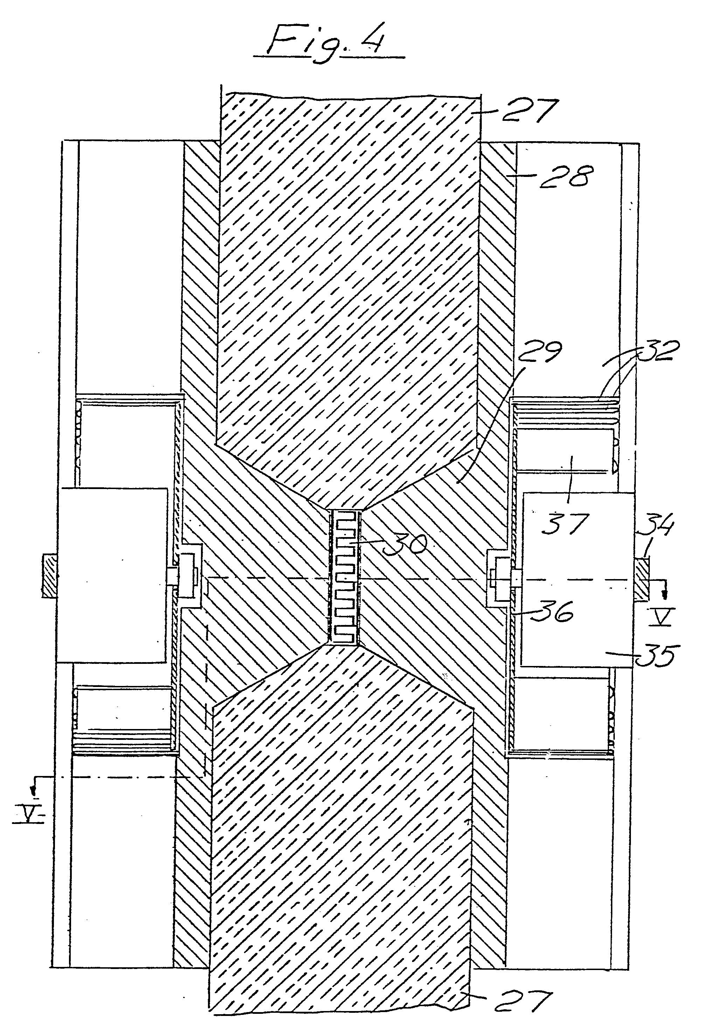

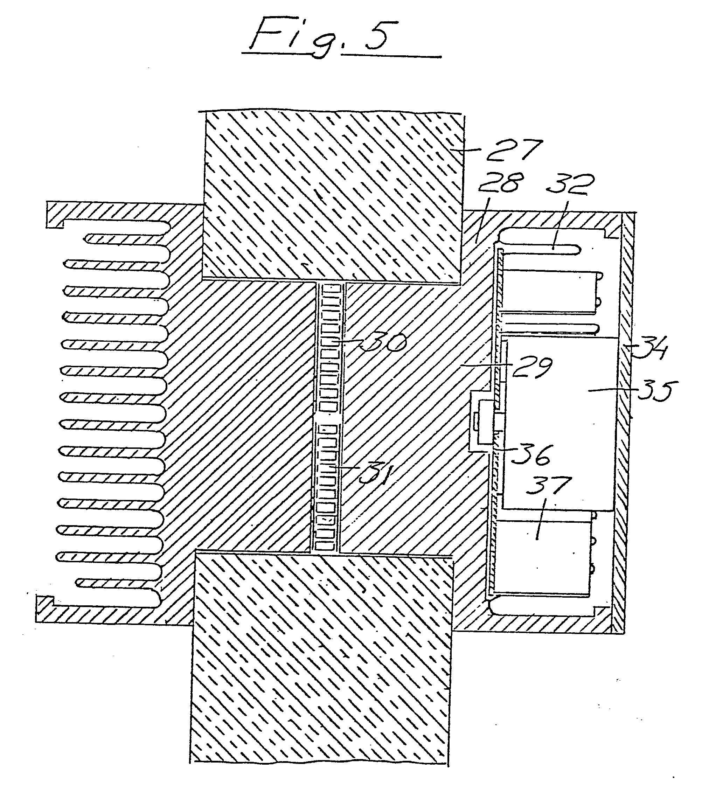

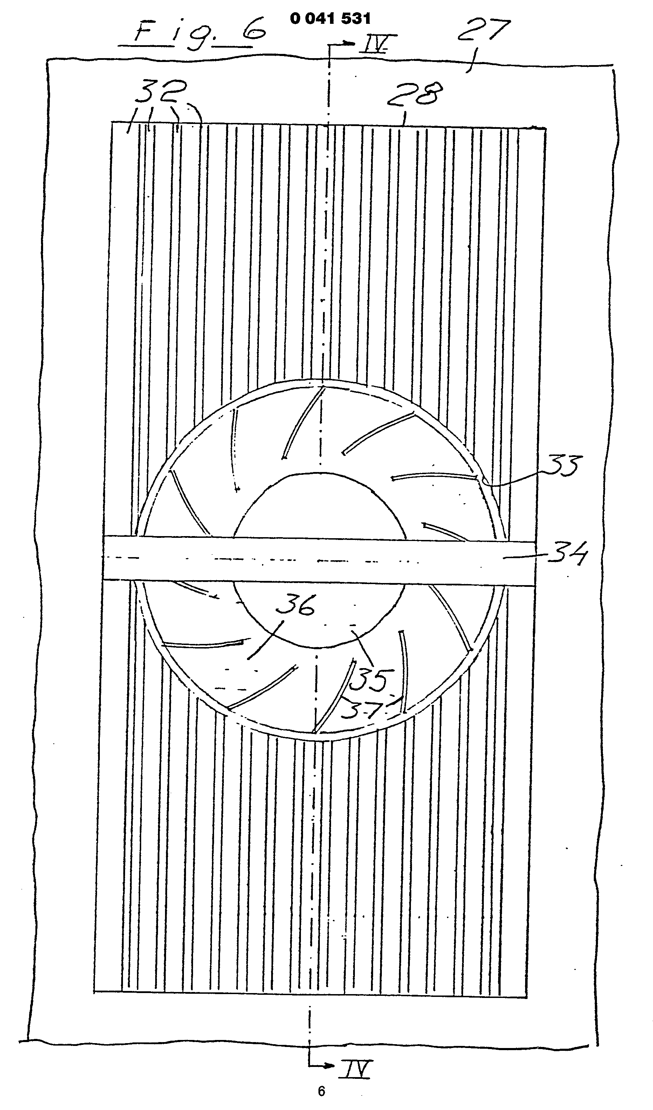

Figs. 4 to 6 show an example of design of the heat exchanging elements serving to effect the heat transfer from the thermo-electric heat pump to the cooled space and to the outer air. As said elements are of identical design, it will be sufficient to describe one of them. The element comprises a plate 28 mounted on the insulating wall 27 of the refrigerator and provided on its inside with a projection 29 projecting into a recess in the wall of the refrigerator and engaging one side of the thermo-electric heat pump units 30, 31 so as to allow the transmission of heat therefrom. On the outside the plate 28 is provided with flanges 32 part of which are cut away to form a cylindrical recess 33 for a fan. The fan is mounted on a supporting bar 34 attached to the two outermost ones of the flanges 32 and comprises a motor 35 and a fan wheel mounted on the shaft of said motor, said fan wheel comprising a rotor plate 36 and a set of vanes 37 attached to said rotor plate. Rotation of the fan wheel causes air to flow outwards from the fan wheel in both directions along the flanges 32, resulting in a greatly improved heat transfer between the element and the air. This advantage is particularly important for the cooling element placed inside the cold space. The element occupies little space. This facilitates the collection and the draining off of condensate formed on the element. As the temperature gradient between the air and the element will be very small (as a rule less than 1 °C), no ice can form on the element at the normal refrigerator temperature of 8 °C.

In the embodiments described the invention is applied to refrigerators. The invention is, however, equally applicable to devices for warm storage, in which case the pumped heat flow is directed inwards, or for the maintenance of a predetermined storage temperature irrespectively of whether it is higher or lower than the temperature of the surroundings, in which case automatic means have to be provided for adapting the direction of the electric current through the thermo-electric units to the conditions, for instance a polarity reversing switch arranged to be automatically controlled by the temperature sensing means of the storage space in such a manner that reversal of the current takes place each time the temperature of the storage space passes a certain limit.

In the embodiments described a switch is arranged in a first position to connect two heat pump units in series and in a second position to connect the two heat pump units in parallel. The device according to the invention may, however, be arranged to provide more than two switch positions or circuit conditions. In a heat pump comprising six identical units these units may, for example, be arranged in a first circuit condition to form a single chain of series connected units, in a second circuit condition to form two parallel connected chains each of which consists of three series connected units, and in a third circuit condition to form three parallel connected chains each of which consists of two series connected units.

**Claims**

1. Device for the cooling or heating of a storage space provided with heat insulating walls, of the type comprising a thermo-electric heat pump arranged to transmit heat between a heat exchanging element inside said space and a heat exchanging element exposed to an outer medium, for example the atmospheric air, said thermo-electric heat pump comprising at least two substantially identical units or groups of units (1, 2 ; 15, 16 ; 30, 31) arranged each to transmit a portion of the pumped heat flow, a source of direct current feeding said heat pump, and a series-parallel switch (A ; B) arranged to connect said units or groups of units to the source of direct current in series or in parallel with each other, characterized in that said source of direct current is of a substantially constant voltage, and in that said units or groups of units are characterized by such a relation between the pumped heat power and the operating current that the highest current which can be caused by said source of current to flow through the series connected units or groups of units is considerably lower than the current caused to flow through the parallel connected units or groups of units when the maximum pumped heat power is to be attained.

2. Device as claimed in claim 1, characterized in that a sensing element (14, Fig. 1 ; C, Fig. 3) sensing the temperature of the cold or warm storage space is arranged to control the switch (A ; B) in such a manner that said switch is set into the parallel position as soon as the temperature rises above or drops below respectively a maximum or minimum value prescribed for the cold or warm storage space, respectively.

3. Device as claimed in claim 1 or 2, characterized in that a sensing element (14, Fig. 1) sensing the temperature of the storage space is arranged to produce a signal which varies continuously with the temperature, and in that a device (7, Fig. 1) for adjusting the electric current through the heat pump is arranged to be controlled by said signal to effect a substantially continuous adjustment of the operating current of said elements or groups at least when connected in series.

4. Device as claimed in claim 3, characterized in that the switch (A) is arranged to be controlled by an electric quantity varying with the current through one of the units (1, 2) or groups of units.

5. Device as claimed in any of the claims 1-4, characterized in that the sensing element (C) sensing the temperature of the cold or warm storage space is arranged to control a contact (c2) for short-circuiting a resistor (25) connected in series with the series connected units (15, 16) or groups in such a way as to cause said contact to close when the temperature of the cold or warm storage space rises above or drops below, respectively, a predetermined value.

6. Device as claimed in any preceding claim, in which a fan (19) driven by an electric motor is arranged in the storage space to produce an air current sweeping the heat exchanging element of the storage space, characterized in that the fan motor is connected in parallel with one (16) of the units (15, 16) or groups.

7. Device as claimed in claim 6, in which a second fan (20) driven by an electric motor is arranged to produce an air current sweeping the outer heat exchanging element (18), characterized in that the fan motor of said second fan (20) is connected in parallel with the other one (15) of the units or groups.

**Ansprüche**

1. Vorrichtung zum Kühlen oder Wärmen eines Lagerraumes mit gegen Wärme isolierenden Wänden, des Typs, der eine thermo-elektrische Wärmepumpe einschliesst, die so eingerichtet ist, dass sie Wärme überträgt zwischen einem Wärmeaustauscher innerhalb des genannten Raumes und einem Wärmeaustauscher, der einem Aussenmedium, z. B. atmosphärischer Luft, ausgesetzt ist, wobei die genannte thermo-elektrische Wärmepumpe einschliesst : mindestens zwei im wesentlichen gleiche Einheiten oder Gruppen von Einheiten (1, 2 ; 15, 16 ; 30, 31), deren jede so eingerichtet ist, dass sie einen Teil des gepumpten Wärmeflusses überträgt, eine Gleichstromquelle zur Versorgung der genannten Wärmepumpe, und einen Serienparallelschalter (A ; B), der eingerichtet ist, die genannten Einheiten oder Gruppen von Einheiten mit einer Gleichstromquelle hintereinander oder parallel zu schalten, dadurch gekennzeichnet, dass die Gleichstromquelle eine im wesentlichen konstante Spannung hat, und dadurch, dass die Einheiten oder Gruppen von Einheiten durch ein solches Verhältnis zwischen der gepumpten Wärmeenergie und dem Betriebsstrom gekennzeichnet sind, dass der höchste Strom, der von der genannten Stromquelle durch die hintereinander geschalteten Einheiten oder Gruppen von Einheiten befördert wird, erheblich niedriger ist als der Strom, der durch die parallel geschalteten Einheiten oder Gruppen von Einheiten befördert wird, wenn maximale gepumpte Wärmeenergie erzielt werden soll.

2. Vorrichtung gemäss Anspruch 1, dadurch gekennzeichnet, dass ein Messelement (14, Fig. 1 ; C, Fig. 3) vorgesehen ist, das die Temperatur des Kalt- oder Warmlagerraumes misst, und das dazu eingerichtet ist, einen Schalter (A ; B) derart zu betätigen, dass der genannte Schalter in parallele Lage geschaltet wird, sobald die Temperatur über bzw. unter einen Maximum- bzw. Minimumwert geht, der für den Kalt- bzw. Warmlagerraum vorgesehen ist.

3. Vorrichtung gemäss Anspruch 1 oder 2, dadurch gekennzeichnet, dass das Messelement (14, Fig. 1), das die Temperatur des Lagerraumes misst, eingerichtet ist, ein Signal zu geben, das sich fortlaufend mit der Temperatur ändert, und dass eine Einrichtung (7, Fig. 1) vorgesehen ist, die den elektrischen Strom durch die Wärmepumpe reguliert und durch das genannte Signal betätigt wird, um eine im wesentlichen fortlaufende Regulierung des Betriebsstromes der genannten Einheiten oder Gruppen von Einheiten zu bewirken, zumindestens wenn sie hintereinander geschaltet sind.

4. Vorrichtung gemäss Anspruch 3, dadurch gekennzeichnet, dass der Schalter (A) dazu eingerichtet ist, durch einen elektrischen Wert geschaltet zu werden, der sich mit dem Strom durch eine der Einheiten (1, 2) oder Gruppen von Einheiten verändert.

5. Vorrichtung gemäss einem der Ansprüche 1 bis 4, dadurch gekennzeichnet, dass das Messelement (C), welches die Temperatur des Kalt- oder Warmlagerraums misst, dazu eingerichtet ist, einen Kontakt (c2) zum Kurzschliessen eines Widerstands (25) zu betätigen, der mit den hintereinander geschalteten Einheiten (15, 16) oder Gruppen so hintereinander geschaltet ist, dass er den genannten Kontakt schliesst, wenn die Temperatur des Kalt- oder Warmlagerraumes über bzw. unter einen vorbestimmten Wert geht.

6. Vorrichtung gemäss einem der vorstehenden Ansprüche, in der ein von einem Elektromotor angetriebener Ventilator (19) in dem Lagerraum angebracht ist, um einen Luftstrom zu bewirken, der über den Wärmeaustauscher des Lagerraumes streicht, dadurch gekennzeichnet, dass der Motor des Ventilators parallel mit einer (16) der Einheiten (15, 16) oder Gruppen geschaltet ist.

7. Vorrichtung gemäss Anspruch 6, in der ein zweiter, von einem Elektromotor angetriebener Ventilator (20) angebracht ist, um einen Luftstrom zu bewirken, der über den äusseren Wärmeaustauscher (18) streicht, dadurch gekennzeichnet, dass der Ventilatormotor des genannten zweiten Ventilators parallel mit der anderen (15) der Einheiten oder Gruppen geschaltet ist.

**Revendications**

1. Dispositif pour le refroidissement ou le chauffage d'un espace de stockage présentant des parois de calorifugeage, du type comportant une pompe à chaleur thermo-électrique agencée pour transmettre la chaleur entre un élément échangeur de chaleur à l'intérieur dudit espace et un élément échangeur de chaleur exposé à un milieu extérieur, par exemple à l'air atmosphérique, ladite pompe à chaleur thermo-électrique comportant au moins deux unités ou groupes d'unités sensiblement identiques (1, 2 ; 15, 16 ; 30, 31) agencés pour transmettre chacun une portion du courant de chaleur pompée, une source de courant continu alimentant ladite pompe à chaleur, et un commutateur en série et en parallèle (A ; B) agencé pour connecter lesdits unités ou groupes d'unités à la source du courant continu en série ou en parallèle, caractérisé en ce que ladite source de courant continu est à une tension sensiblement constante et en ce que lesdits unités ou groupes d'unités sont caractérisés par un rapport tel entre l'énergie thermique pompée et le courant opératoire que le courant le plus élevé qui peut être obligé par ladite source de courant à s'écouler à travers les unités ou groupes d'unités connectés en série soit considérablement plus faible que le courant obligé à s'écouler à travers les unités ou groupes d'unités connectés en parallèle quand l'énergie thermique pompée maximale doit être atteinte.

2. Dispositif selon la revendication 1, caractérisé en ce qu'un élément détecteur (14, figure 1 ; C, figure 3) qui détecte la température de l'espace de stockage froid ou chaud est agencé pour commander le commutateur (A ; B) de manière que ledit commutateur soit établi en position parallèle dès que la température monte au-dessus ou descend au-dessous, respectivement, d'une valeur maximale ou minimale prescrite pour l'espace de stockage à froid ou à chaud, respectivement.

3. Dispositif selon la revendication 1 ou 2, caractérisé en ce qu'un élément détecteur (14, figure 1) qui détecte la température de l'espace de stockage est agencé pour produire un signal qui varie continuellement avec la température, et en ce qu'un dispositif (7, figure 1) pour régler le courant électrique à travers la pompe à chaleur est agencé pour être réglé par ledit signal afin d'effectuer un réglage pratiquement continu du courant opératoire desdits éléments ou groupes au moins quand ils sont connectés en série.

4. Dispositif selon la revendication 3, caractérisé en ce que le commutateur (A) est agencé pour être réglé par une quantité électrique variant avec le courant à travers l'une des unités (1, 2) ou groupes d'unités.

5. Dispositif selon l'une quelconque des revendications 1 à 4, caractérisé en ce que l'élément détecteur (C) qui détecte la température de l'espace de stockage froid ou chaud est agencé pour régler un contact (c2) afin de mettre en court-circuit une résistance (25) connectée en série avec les unités (15, 16) ou groupes connectés en série de façon à amener ledit contact à se fermer quand la température de l'espace de stockage froid ou chaud monte au-dessus ou descend au-dessous, respectivement, d'une valeur prédéterminée.

6. Dispositif selon l'une quelconque des revendications précédentes, dans lequel un ventilateur (19) entraîné par un moteur électrique est agencé dans l'espace de stockage pour produire un courant d'air balayant l'élément échangeur de chaleur dans l'espace de stockage, caractérisé en ce que le moteur du ventilateur est connecté en parallèle avec l'une (16) des unités (15, 16) ou groupes.

7. Dispositif selon la revendication 6, dans lequel un second ventilateur (20) entraîné par un moteur électrique est agencé pour produire un courant d'air qui balaye l'élément extérieur échangeur de chaleur (18), caractérisé en ce que le moteur de ce second ventilateur (20) est connecté en parallèle avec l'autre (15) des unités ou groupes.

Fig. 1

Fig. 2

# Fig. 3

# Fig. 4

# Fig. 5

Fig. 6

0 041 531